Europäisches Patentamt

European Patent Office

Office européen des brevets

(19)

(11) Numéro de publication : **0 188 946 B1**

# (12) FASCICULE DE BREVET EUROPÉEN

(45) Date de publication du fascicule du brevet :
01.02.89

(21) Numéro de dépôt : 85402518.6

(22) Date de dépôt : 17.12.85

(51) Int. Cl.⁴ : **H 01 L 29/92**

(54) **Elément capacitif intégré sur une pastille de circuit intégré, et procédé de réalisation de cet élément actif.**

(30) Priorité : 21.12.84 FR 8419647

(43) Date de publication de la demande :
30.07.86 Bulletin 86/31

(45) Mention de la délivrance du brevet :
01.02.89 Bulletin 89/05

(84) Etats contractants désignés :
DE GB NL

(56) Documents cités :
EP-A- 0 098 671
EP-A- 0 118 878
GB-A- 2 119 570
GB-A- 2 138 207
IEEE ELECTRON DEVICE LETTERS, vol. EDL-3, no. 5,
mai 1982, pages 127-129, IEEE, New York, US; M.E.
ELTA et al.: "Tantalum oxide capacitors for GaAs
monolithic integrated circuits"
idem
ELECTRONICS LETTERS, vol. 18, no. 5, 4 mars 1982,
pages 197-198, Londres, GB; M. BINET: "Capacitors
made by anodisation of aluminum for wideband GaAs
ICs"
PATENTS ABSTRACTS OF JAPAN, vol. 7, no. 251 (E-
209) [1396], 8 novembre 1983; & JP - A - 58 137 242
(SUWA SEIKOSHA K.K.) 15-08-1983

(73) Titulaire : **THOMSON-CSF**
**173, Boulevard Haussmann**
**F-75379 Paris Cédex 08 (FR)**

(72) Inventeur : **Girma, Thierry**
**THOMSON-CSF SCPI 173, bld Haussmann**
**F-75379 Cedex 08 (FR)**
Inventeur : **Jay, Paul**
**THOMSON-CSF SCPI 173, bld Haussmann**
**F-75379 Cedex 08 (FR)**

(74) Mandataire : **Taboureau, James et al**
**THOMSON-CSF SCPI 19, avenue de Messine**
**F-75008 Paris (FR)**

## Description

La présente invention concerne un élément capacitif, de type métal-isolant-métal, intégré dans le cristal d'un circuit intégré, et dont la faible surface occupée sur ce cristal permet d'augmenter la densité d'intégration du circuit intégré. Cet élément capacitif possède une surface effective de capacité plus grande que la surface géométrique qu'il occupe sur le cristal semiconducteur, parce qu'il est enterré verticalement dans le substrat. L'invention concerne également le procédé de réalisation de cet élément capacitif.

Pour qu'une capacité puisse être intégrée dans un circuit intégré, il est obligatoire qu'elle soit de très petites dimensions géométriques, à l'échelle de la pastille de circuit intégré, ce qui fait que l'invention concerne essentiellement les circuits intégrés hyperfréquences dans lesquels les capacités sont de très faibles valeurs. Les supports de ces circuits intégrés hyperfréquences sont actuellement en matériau III-V, tels que GaAs, InP, ou des alliages ternaires ou quaternaires de Ga, As, Al, Sb, In... etc. Cependant l'invention peut également être appliquée aux circuits intégrés sur silicium. Dans tous les cas, il est nécessaire que la région du substrat qui supporte l'élément capacitif soit isolante ou semi-isolante : GaAs intrinsèque, semi-isolant par fabrication, ou silicium oxydé en surface pour le rendre isolant puisqu'on ne sait pas réaliser des substrats de silicium isolant.

L'élément capacitif selon l'invention est réalisé verticalement par rapport au substrat au lieu d'être réalisé horizontalement selon l'art connu. Il est caractérisé par sa forme géométrique qui est un sillon creusé dans le substrat, pour chaque élément capacitif, ou une série de sillons formant une grecque si la capacité d'un seul élément capacitif dans un seul sillon n'est pas suffisante par rapport à la capacité qui est nécessaire pour le circuit intégré. Il est en outre caractérisé par sa structure : la première armature de l'élément capacitif est formée par un premier métal, choisi parmi ceux qui fournissent un oxyde par oxydation anodique ou par plasma d'oxygène ; le diélectrique est formé par une couche d'oxyde de ce premier métal, et la deuxième armature est formée par un second métal, qui n'est pas obligatoirement le même que le premier métal mais peut au contraire être inoxydable.

De façon plus précise l'invention a pour objet un élément capacitif intégré conforme à la revendication 1 et un procédé de fabrication d'un tel élément conforme à l'une des revendications 7 ou 8.

L'invention sera mieux comprise par la description suivante d'un exemple de réalisation d'éléments capacitifs, ainsi que par la description de son procédé de réalisation qui explique mieux la structure de l'élément capacitif, ces descriptions s'appuyant sur les figures jointes en annexe qui représentent :

figure 1 : coupe du masque de photorésist pour la gravure des sillons d'un ensemble d'éléments capacitifs selon l'invention ;

figure 2 : coupe d'un ensemble de sillons gravés dans un substrat ;

figure 3 : coupe d'un sillon dans lequel est déposée la première couche métallique ;

figure 4 : coupe du sillon de la figure 3, après oxydation de la première couche de métal ;

figure 5 : courbes de V et I en fonction du temps pour l'oxydation anodique de la première couche de métal ;

figure 6 : coupe du sillon de la figure 4 après dépôt de la deuxième couche de métal, constituant ainsi l'élément capacitif selon l'invention ;

figure 7 : représentation de deux façons pour prendre le contact électrique sur l'armature supérieure de l'élément capacitif selon l'invention.

L'invention concerne donc un élément capacitif réalisé dans un sillon creusé dans le cristal d'un circuit intégré, cet élément capacitif étant constitué par deux couches métalliques, dont la première, déposée directement sur le cristal semiconducteur, est oxydée de façon à former une couche d'oxyde métallique qui constitue le diélectrique de la capacité. Cependant la description du procédé de réalisation de cet élément capacitif permettra de mieux en comprendre la structure, et cette description s'appuiera à titre d'exemple non limitatif sur un substrat de GaAs.

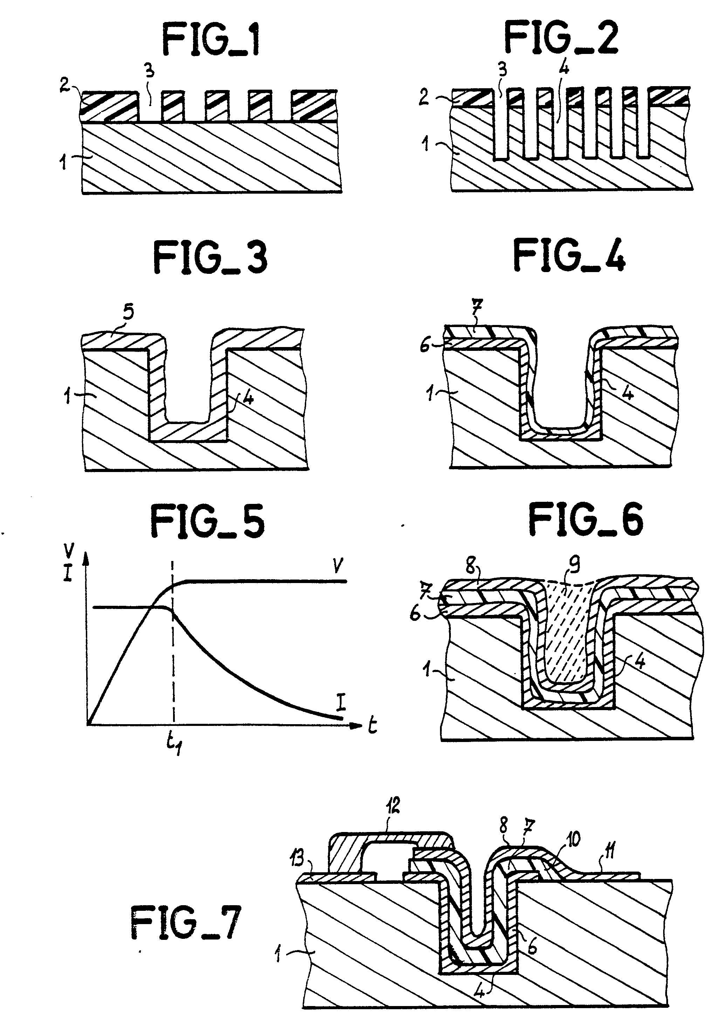

Ainsi, le procédé de réalisation de l'élément capacitif commence, tel que présenté en figure 1, par le dépôt d'un masque de photorésist 2 sur une pastille de substrat semi-isolant 1. Dans la couche de photorésist 2 sont gravées, par des moyens de masquage connus, des fentes 3 qui correspondent aux sillons qui sont à creuser dans le substrat 1. Les détails de technique de réalisation de ce masque de photorésist font partie de l'art connu et nécessitent selon les cas l'emploi de plusieurs couches de résine, si nécessaire, et l'orientation correcte des fentes 3 par rapport à l'orientation du réseau cristallographique du substrat semiconducteur 1.

En figure 2, des sillons 4 sont gravés dans le substrat 1, par des techniques de gravures anisotropiques, telles l'usinage ionique ou la gravure sèche par attaque en milieu plasma. Les dimensions des sillons 4 sont, à titre d'exemple, 5 microns de profondeur, 1 micron de largeur, avec un espacement de 1 micron entre sillons. C'est pourquoi, bien que l'invention concerne un élément capacitif unitaire, la réalisation englobe plus généralement un réseau de plusieurs sillons étroits et profond pour obtenir la valeur de capacité requise par le circuit électrique. Lorsque les sillons 4 ont été creusés par gravure anisotropique, le masque de résine 2 est ensuite éliminé.

La figure 3 représente la coupe de l'un des sillons 4 de la figure 2. Une couche d'un premier métal 5 est déposée dans ce sillon, ainsi que sur la surface supérieure du substrat 1 par un dépôt isotropique tel que la pulvérisation cathodique.

On sait que la pulvérisation cathodique dépose sur les parois du sillon 4 une épaisseur de métal qui est sensiblement la même que celle qui est déposée dans le fond du sillon 4 ou sur la surface supérieure du substrat. Ce premier métal est choisi parmi les métaux qui s'oxydent soit par oxydation anodique, soit par plasma d'oxygène, ,et donnent des oxydes de constante diélectrique élevée : les métaux préférés sont l'aluminium, le tantale, le niobium. L'épaisseur de la couche 5 de ce premier métal est d'au moins 200 nm (2 000 Angstroms). Il n'est pas nécessaire que l'épaisseur de cette couche 5 soit homogène, mais qu'elle soit toujours plus épaisse qu'une valeur inférieure qui dépend de l'épaisseur d'oxyde recherchée pour former le condensateur. Cette valeur inférieure est telle que, après oxydation partielle de la couche 5 du premier métal, il reste toujours une partie de la couche 5 qui soit métallique de façon à former la première armature de la capacité.

La couche 5 du premier métal est alors oxydée et donne, comme représentée en figure 4, une couche 6 du premier métal, de moindre épaisseur que ne l'était la couche 5 avant oxydation, ladite couche 6 étant recouverte d'une couche 7 d'oxyde du premier métal. L'oxydation peut se faire soit par oxydation anodique, en bain, avec une cathode de platine, soit par un plasma d'oxygène. Cependant l'oxydation anodique est préférable parce que l'épaisseur d'oxyde formée est une fonction de la tension appliquée sur la cathode. Par conséquent, l'épaisseur de l'oxyde 7 ne dépend que de la tension appliquée pour l'anodisation et une épaisseur constante de la couche 7 est obtenue même sur les parois du sillon 4, là où la métallisation est, généralement, moins régulière que sur les surfaces horizontales du cristal semiconducteur et du fond du sillon 4. La tension d'anodisation est choisie pour que l'oxyde ait une épaisseur conforme à l'utilisation prévue pour la capacité, et qui peut être par exemple de 1 000 angstroms pour la couche d'oxyde 7 si la couche 5 de premier métal avait 2 000 angstroms d'épaisseur au moment du dépôt.

La figure 5 représente les deux couches de tension V et d'intensité I en fonction du temps au cours de l'oxydation anodique de métaux tels que l'aluminium, le tantale et le niobium. Ces courbes montrent que, lorsqu'on applique la tension, au début de l'opération d'oxydation anodique, la tension croît régulièrement avec le temps jusqu'à atteindre une valeur qu'elle ne dépasse plus par la suite. Simultanément l'intensité I a une valeur qui reste constante tant que la tension V croît, puis l'intensité I tend vers 0, dans le temps, pendant que la tension V reste constante à son maximum. Lorsqu'on a atteint $T_1$ qui correspond à la stabilité de la tension V et à la décroissance de l'intensité I, la poursuite de l'opération anodique ne sert absolument pas à augmenter l'épaisseur de la couche 7 d'oxyde, mais peut être utile pour assurer une régularisation de cette couche, par exemple en bouchant des trous ou en lissant sa surface. De toutes façons, l'épaisseur de la couche d'oxyde 7 étant fixée par la tension d'oxydation anodique, on sait que si une tension de 150 volts par exemple a été utilisée l'élément capacitif tient en tension qu'à une valeur légèrement inférieure à la tension de formation de l'oxyde : par exemple, dans ce cas il tient jusqu'à 120 volts.

En figure 6, l'élément capacitif est complété par le dépôt d'une couche 8 d'un second métal également déposé par pulvérisation cathodique afin de bien couvrir les surfaces de la couche 7 d'oxyde, en particulier la surface latérale dans le sillon 4. La couche 8 du second métal forme donc la seconde armature d'une capacité, dont la première armature est la couche 6 de premier métal et dont le diélectrique est la couche 7 de l'oxyde du premier métal.

Bien entendu, les limites des différentes couches métalliques et d'oxyde sur la face supérieure du cristal 1 de circuit intégré sont définies au cours des opérations précédentes par masquage et par lithographie, afin que la couche 8 de second métal ne vienne pas court-circuiter la couche 6 de premier métal. Ces opérations de définitions en surface du cristal 1 des métallisations font partie des connaissances de l'homme de l'art, de même que les métallisations de prise de contact qui sont nécessaires pour que l'élément capacitif selon l'invention soit utilisable dans un circuit.

Cependant la couche 8 de second métal peut être avantageusement rechargée par un procédé électrolytique, de façon à complètement obstruer le sillon 4, tel que cela est représenté comme une possibilité par des pointillés 9 sur la figure 6. En effet, si la seconde armature 8 de l'élément capacitif est ainsi rechargée en métal et que le sillon 4 se trouve totalement obstrué par du métal, cela diminue la résistivité du condensateur et amène une faible résistance électrique pour cette armature 8.

La figure 7 donne la représentation de deux façons différentes de prendre le contact électrique sur la seconde armature de l'élément capacitif, c'est-à-dire sur l'armature supérieure, couche métallique 8. Une première prise de contact est représentée sur la partie droite de cette figure. Si l'épaisseur de l'oxyde 7 du premier métal le permet, c'est-à-dire si la tension de service ou l'épaisseur de diélectrique requise pour une certaine capacité conviennent, la couche d'oxyde 7 enveloppe correctement la première couche métallique 6, à son extrémité 10 et dans ces conditions la deuxième couche métallique 8 peut envelopper correctement la couche d'oxyde 7, sans qu'il y ait de rupture au franchissement de la marche 10 : ainsi il est possible de réaliser un plot de prise de contact 11 sur la face supérieure de la pastille de circuit intégré ce plot étant du même métal que la couche 8 du second métal.

Par contre si l'épaisseur de la couche d'oxyde 7 est trop importante, le risque est grand que la couche d'oxyde 7 casse ou s'amincisse lorsqu'elle franchit la marche 10 constituée par la couche 6 du premier métal. Dans ce cas il est préférable d'assurer la prise de contact électrique sur la couche 8 du second métal au moyen de ce que l'on appelle un pont d'air 12, qui est en fait une métallisation formant un pont et laissant un espace d'aire entre elle et la pastille semiconductrice. Ce pont d'air repose par une extrémité sur la couche 8 du premier métal et par une seconde extrémité sur une métallisation 13 de prise de contact.

La capacité d'un élément capacitif tel que décrit est très faible, puisque sa longueur développée, pour un sillon de 5 × 1 microns, est de 11 microns, tandis que la longueur du sillon, mesurée en surface de la pastille de circuit intégré, ne peut pas elle-même être importante, sur une pastille elle-même petite. C'est pourquoi la capacité selon l'invention est préférentiellement réalisée sous forme d'une grecque, telle que représentée en figure 2, qui regroupe une pluralité d'éléments capacitifs. Dans un tel cas, les couches métalliques et d'oxyde métallique recouvrent les parois des sillons mais aussi la surface supérieure du substrat comprise entre les sillons, de façon à assurer la continuité électrique. La valeur de capacité désirée est alors obtenue en mettant en série un certain nombre d'éléments capacitifs — l'association géométrique en série correspond à un montage électrique en parallèle de petites capacités — Les prises de contacts électriques ne sont dans ce cas réalisées qu'une seule fois pour l'ensemble des sillons.

En raison des faibles valeurs de capacités obtenues, l'invention s'applique de préférence aux circuits intégrés hyperfréquences sur GaAs ou matériaux correspondants, mais elle trouve également des applications pour les capacités de découplage ou de déphasage, de faible valeur, dans les circuits intégrés sur silicium.

**Revendications**

1. Elément capacitif intégré sur un substrat (1) de circuit intégré en cristal de silicium rendu isolant en surface ou en cristal d'un matériau semi-isolant ou isolant, cet élément capacitif étant réalisé dans au moins un sillon (4) à parois verticales du substrat (1) dont la profondeur est supérieure à la largeur, et étant tel que la première armature de l'élément capacitif est formée par une couche d'un premier métal oxydable, le diélectrique est formé par une couche de l'oxyde du premier métal, et la seconde armature est formée par une couche de métal.

2. Elément capacitif selon la revendication 1, caractérisé en ce que la première armature (7) est constituée par un métal donnant un oxyde par oxydation anodique, tel que Al, Ta, Nb.

3. Elément capacitif selon la revendication 1, caractérisé en ce que, après formation de l'élément capacitif dans le sillon (4), une recharge électrolytique de métal (9), remplissant le sillon (4), diminue la résistivité de l'élément capacitif.

4. Elément capacitif selon la revendication 1, caractérisé en ce que la couche (6) du premier métal s'étend partiellement sur la face supérieure du substrat (1), pour prise de contact électrique sur la première armature.

5. Elément capacitif selon la revendication 4, caractérisé en ce que la couche (7) de diélectrique recouvre, en face supérieure du substrat (1), la couche (6) du premier métal, et forme un débordement (10) permettant à la couche (8) du second métal de franchir la marche de la couche (6) du premier métal, la couche (8) du second métal formant sur la face supérieure du substrat (1) une prise de contact électrique (11) sur la deuxième armature.

6. Elément capacitif selon la revendication 4, caractérisé en ce qu'un « pont d'air » constitué par une structure métallique (12), dont une extrémité est en contact avec la couche (8) du second métal et l'autre extrémité est en contact avec une métallisation (13) supportée par le substrat (1), forme une prise de contact électrique sur la deuxième armature.

7. Procédé de réalisation d'un élément capacitif selon la revendication 1, caractérisé en ce qu'il est formé par deux couches métalliques (5 et 8), la première couche (5), épaisse, étant partiellement oxydée pour former une couche (7) d'oxyde qui constitue le diélectrique de l'élément capacitif.

8. Procédé de réalisation d'un élément capacitif selon la revendication 1, caractérisé en ce qu'il comporte la suite d'opérations suivantes :

— sur un substrat (1) en matériau semi-isolant ou isolant, dépôt d'un masque de photorésist (2) comportant au moins un motif (3) respectant l'orientation du réseau cristallographique du substrat et dégageant le substrat (1),

— gravure anisotropique du substrat (1) pour former au moins un sillon (4), plus profond que large, et élimination du masque de photorésist (2) ;

— dépôt dans le sillon (4) et, partiellement, sur le substrat (1) par un procédé isotropique, d'une couche (5) d'un premier métal, oxydable,

— oxydation partielle de la couche (5) du premier métal, laissant une couche (6) de métal et formant une couche (7) d'oxyde du premier métal,

— dépôt sur la couche d'oxyde (7) par un procédé isotropique d'une couche (8) d'un second métal,

— formation des prises de contacts électriques (11, 12, 13) sur les couches (6, 8) métalliques.

9. Procédé de réalisation d'un élément capacitif selon la revendication 8, caractérisé en ce que la couche d'oxyde (7) du premier métal est obtenue par oxydation anodique.

10. Procédé de réalisation d'un élément capacitif selon la revendication 9, caractérisé en ce que l'épaisseur formée d'oxyde et la tenue en tension de l'élément capacitif dépendent uniquement de la tension d'anodisation.

**Claims**

1. A capacitive element integrated on an integrated circuit substrate (1) consisting of a silicon crystal rendered insulating on its surface or of a crystal of semi-insulating or entirely insulating material, wherein the capacitive element is realized within at least one groove (4) of the substrate (1) having vertical walls, the depth of that groove exceeding its width, and wherein the first plate of the capacitive element is formed by a layer of a first oxidizable metal, the dielectric is formed by an oxide layer of the first metal and the second plate is formed by a metal layer.

2. A capacitive element according to claim 1, characterized in that the first plate (7) is constituted by a metal producing an oxide by anodic oxidation, such as Al, Ta, Nb.

3. A capacitive element according to claim 1, characterized in that after the formation of the capacitive element within the groove (4), an electrolytic metal refill (9) filling the groove (4) reduces the resistivity of the capacitive element.

4. A capacitive element according to claim 1, characterized in that the layer (6) of the first metal extends partially over the upper surface of the substrate (1) for providing an electric access contact to the first plate.

5. A capacitive element according to claim 4, characterized in that the dielectric layer (7) covers the layer (6) of the first metal on the upper surface of the substrate (1) and forms an overhanging portion (10) permitting the layer (8) of the second metal to pass over the step of the layer (6) of the first metal, the layer (8) of the second metal forming on the upper surface of the substrate (1) an electric access contact (11) to the second plate.

6. A capacitive element according to claim 4, characterized in that an « air bridge » constituted by a metallic structure (12), of which one end is in contact with the layer (8) of the second metal and of which the other end is in contact with a metallization (13) supported by the substrate (1), forms an electric access contact to the second plate.

7. A method for making a capacitive element according to claim 1, characterized in that it is composed of two metal layers (5 and 8), the first one (5) being thick and partially oxidized in order to constitute an oxide layer (7) and thus the dielectric layer of the capacitive element.

8. A method for making a capacitive element according to claim 1, characterized in that it comprises the following process steps in succession :
— deposition on a substrate (1) of semi-insulating or entirely insulating material of a photoresist mask (2) comprising at least one pattern (3) and respecting the orientation of the crystal lattice of the substrate,
— anisotropic engraving of the substrate (1) for forming at least one groove (4), whichis deeper than large, and elimination of the photoresist mask (2),
— deposition of a layer (5) of a first oxidizable metal within the groove (4) and partially on the substrate (1) by an isotropic process,
— partial oxidation of the layer (5) of the first metal, while still leaving a metal layer (6), thus forming an oxide layer (7) of the first metal,
— deposition of a layer (8) of a second metal on the oxide layer (7) by an isotropic process,
— formation of electric access contacts (11, 12, 13) on the metal layers (6, 8).

9. A method for making a capacitive element according to claim 8, characterized in that the oxide layer (7) of the first metal is obtained by anodic oxidation.

10. A method for making a capacitive element according to claim 9, characterized in that the thickness of the oxide layer obtained and the voltage strength of the capacitive element depend only upon the anodisation voltage.

**Patentansprüche**

1. Auf einem Substrat (1) eines integrierten Schaltkreises integriertes Kapazitätselement, bestehend aus einem an der Oberfläche isolierend gemachten Siliciumkristall oder einem Kristall aus einem halbisolierenden oder isolierenden Material, wobei das Kapazitätselement in mindestens einer Rille (4) des Substrats (1) mit senkrechten Wänden ausgebildet ist und die Tiefe der Rille größer als die Breite ist, und wobei der erste Belag des Kapazitätselements aus einer Schicht eines ersten oxidierbaren Metalls, das Dielektrikum aus einer Oxidschicht des ersten Metalls und der zweite Belag aus einer Metallschicht gebildet ist.

2. Kapazitätselement nach Anspruch 1, dadurch gekennzeichnet, daß die erste Elektrode (7) aus einem Metall besteht, welches ein Oxid durch anodische Oxidation ergibt, wie Al, Ta, Nb.

3. Kapazitätselement nach Anspruch 1, dadurch gekennzeichnet, daß nach dem Ausbilden des Kapazitätselementes in der Rille (4) eine elektrolytische Metallaufbringung (9), die die Rille (4) füllt, den spezifischen Widerstand des Kapazitätselements verringert.

4. Kapazitätselement nach Anspruch 1, dadurch gekennzeichnet, daß sich die erste Metallschicht (6) des teilweise über die obere Fläche des Substrats (1) als elektrischer Kontaktanschluß an den ersten Belag erstreckt.

5. Kapazitätselement nach Anspruch 4, dadurch gekennzeichnet, daß die Dieletrikumschicht (7) auf der oberen Fläche des Substrats (1) die erste Metallschicht (6) überdeckt und einen Überstand (10) bildet, der der zweiten Metallschicht (8) die Stufe der ersten Metallschicht (6) zu überwinden hilft, wobei die zweite Metallschicht (8) auf der oberen Fläche des Substrats (1) einen elektrischen Kontaktanschluß (11) an den zweiten Belag bildet.

6. Kapazitätselement nach Anspruch 4, dadurch gekennzeichnet, daß eine durch eine metallische Struktur (12) gebildete « Luftbrücke », deren eines Ende in Kontakt mit der zweiten Metallschicht (8) und deren anderes Ende in Kontakt mit einer Metallisierung (13) auf dem Substrat (1) steht, die einen elektrischen Kontaktanschluß an den zweiten Belag bildet.

7. Verfahren zur Herstellung eines Kapazitätselements nach Anspruch 1, dadurch gekennzeichnet, daß es aus zwei metallischen Schichten (5 und 8) gebildet wird, wobei die erste, dicke Schicht (5) teilweise zur Bildung einer Oxidschicht (7) oxidiert ist, welche das Dielektrikum des Kapazitätselements bildet.

8. Verfahren zur Herstellung eines Kapazitätselements nach Anspruch 1, dadurch gekennzeichnet, daß es folgende Arbeitsschritte umfaßt :

— Abscheidung einer Fotoresistmaske (2) mit mindestens einem Motiv (3) unter Respektierung der kristallographischen Achsen des Substrates auf einem Substrat (1) aus halbisolierendem oder isolierendem Material,

— anisotropes Gravieren des Substrates (1) zur Bildung mindestens einer Rille (4) die tiefer als breit ist, und Entfernung der Fotoresistmaske (2),

— Abscheidung einer Schicht (5) eines ersten oxidierbaren Metalls in der Rille (4) und, teilweise, auf dem Substrat (1), durch ein isotropes Verfahren,

— Teiloxidation der ersten Metallschicht (5) unter Belassung einer Metallschicht (6) und Bildung einer Oxidschicht (7) des ersten Metalls,

— Abscheidung einer Schicht (7) eines zweiten Metalles auf der Oxidschicht (7) durch ein isotropes Verfahren,

— Bildung der elektrischen Kontaktanschlüsse (11, 12, 13) auf den Metallschichten (6, 8).

9. Verfahren zur Herstellung eines Kapazitätselements nach Anspruch 8, dadurch gekennzeichnet, daß die Oxidschicht (7) des ersten Metalls durch anodische Oxidation erhalten wird.

10. Verfahren zur Herstellung eines Kapazitätselements nach Anspruch 9, dadurch gekennzeichnet, daß die Dicke des gebildeten Oxids und die Spannungsfestigkeit des Kapazitätselements einzig von der Anodisierungsspannung abhängen.

EP 0 188 946 B1

FIG_1

FIG_2

FIG_3

FIG_4

FIG_5

FIG_6

FIG_7